(19) Europäisches Patentamt
European Patent Office
Office européen des brevets

(11) **EP 1 940 205 A2**

(12) **EUROPEAN PATENT APPLICATION**

(43) Date of publication:
**02.07.2008 Bulletin 2008/27**

(51) Int Cl.:
**H05K 1/02** *(2006.01)*

(21) Application number: **07150168.8**

(22) Date of filing: **19.12.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **26.12.2006 JP 2006350285**

(71) Applicant: **Kabushiki Kaisha Toshiba**
**Minato-ku,**
**Tokyo 105-8001 (JP)**

(72) Inventor: **Saito, Shinichiro**
**Tokyo 105-8001 (JP)**

(74) Representative: **Henkel, Feiler & Hänzel**
**Patentanwälte**
**Maximiliansplatz 21**
**80333 München (DE)**

(54) **Microwave circuit board**

(57) A microwave circuit board includes: a board made of insulator; a metallic conductor to transfer an electric signal which is formed on at least one of a main surface and a rear surface of the board; and an electric power layer formed on the rear surface of the board and/or in the board. The board includes an dielectric constant-reducing mechanism so as to reduce an effective dielectric constant of the board.

# FIG. 1

EP 1 940 205 A2

**Description**

CROSS-REFERENCE TO RELATED APPLICATIONS

This application is based upon and claims the benefit of priority from the prior Japanese Patent Application No. 2006-350285, filed on December 26, 2006; the entire contents of which are incorporated herein by reference.

BACKGROUND OF THE INVENTION

1. FIELD OF THE INVENTION

The present invention relates to a microwave circuit board to transfer an electric signal with a frequency within a microwave frequency range.

2. DESCRIPTION OF THE RELATED ART

With a conventional printed-wiring board, conventionally, a high frequency signal is transferred under a transfer mode using a micro strip line (MSL), a strip line (SL) or a coplanar waveguide with or without GND(CPW). The printed-wiring board would be employed for various electronic devices at present. It becomes important to cope with the inherent loss of a material to be utilized for the printed-wiring board, that is, the dielectric loss of the material in order to maintain the quality of the signal waveform with the high speed of the operating frequency because the dielectric loss depends on the frequency of the signal so as to mainly deteriorate the signal waveform due to the ISI (intersymbol interference).
The dielectric loss inherently means the heat generation originated from the follow of the dipole generated in the dielectric substance for the AC electric field, and can be represented by the equation (1)

$$Loss = K \times f \times \sqrt{\varepsilon_r} \times \tan \delta \qquad (1)$$

However, since the dielectric loss is the inherent loss of the dielectric material, a conventional improvement is directed at the improvement of the dielectric material of the board (the reduction of the dielectric constant and the dielectric tangent). Concretely, such an attempt is made as forming the board of ceramic material such as fluorine based ceramic material or alumina. Then, such an attempt is made as foaming the dielectric material and thus, reducing the effective dielectric constant of the dielectric material so that the dielectric loss and the deterioration of the signal waveform of the printed-wiring board can be reduced (refer to References 1 to 3).
It is proposed that the printed-wiring board is rendered porous to reduce the effective dielectric constant thereof so that the dielectric loss and the deterioration of the signal waveform of the printed-wiring board can be reduced (refer to References 2 and 4). It is also proposed that a plurality of through-holes are formed at the printed-wiring board in the thickness direction thereof to reduce the effective dielectric constant thereof so that the dielectric loss and the deterioration of the signal waveform of the printed-wiring board can be reduced (refer to Reference 5).
The above-described conventional techniques can not reduce the effective dielectric constant of the board material of the printed-wiring board sufficiently so that the dielectric loss and the deterioration of the signal waveform of the printed-wiring board can not be reduced sufficiently. Particularly, according to the conventional technique disclosed in Reference 5, the adhesive to join the metallic conductor with the board is infiltrated into the pores so that the effective constant of the board material can not be reduced sufficiently. As a result, the dielectric loss and the deterioration of the signal waveform of the printed-wiring board can not be reduced sufficiently. In addition, in Reference 5, it is required to provide a pair of signal electrodes on both surfaces of the porous board. With Reference 5, therefore, the usage of printed-wiring board is anomaly so that the printed-wiring board can not be applied for a normal printed-wiring board with a GND plane.

[Reference 1] JP-B 62-16566 (KOKOKU)
[Reference 2] JP-A 8-228105 (KOKAI)
[Reference 3] JP-A 2001-7610 (KOKAI)
[Reference 4] JP-A 4-257287 (KOKAI)
[Reference 5] JP-A 2003-115705 (KOKAI)

BRIEF SUMMARY OF THE INVENTION

It is an object of the present invention to provide a printed-wiring board which is made of a not expensive material easily available and can reduce the effective dielectric constant, that is, the dielectric loss of the printed-wiring board so that the deterioration of the signal waveform, the electric power loss and the reflecting energy of the printed-wiring board can be reduced sufficiently.

In order to achieve the above object, an aspect of the present invention relates to a microwave circuit board, including: a board made of insulator; a metallic conductor to transfer an electric signal which is formed on at least one of a main surface and a rear surface of said board; and an electric power layer formed on the rear surface of the board and/or in the board; wherein the board includes an dielectric constant-reducing mechanism so as to reduce an effective dielectric constant of the board.

According to the aspect of the present invention, since the microwave circuit board includes the independent dielectric constant-reducing mechanism in the board, the effective dielectric constant of the board, that is, the effective dielectric constant of the microwave circuit board can be reduced by the mechanism. As a result, the dielectric loss, the electric power loss from the dielectric loss, the reflecting energy and the deterioration of the waveform of the microwave circuit board can be reduced.

Moreover, since an electromagnetic wave can be confined in the microwave circuit board, the electromagnetic radiation from the metallic conductor, through which the electric signal (s) are transferred, can be reduced. Then, even though a plurality of metallic conductors are prepared and a high frequency current is flowed simultaneously in the metallic conductors, the crosstalk between the metallic conductors can be reduced because the line coupling capacitance between the metallic conductors depends on the dielectric constant of the effective board and is decreased as the dielectric constant is decreased.

The dielectric constant-reducing mechanism uses a gaseous insulator. The gaseous insulator can be an airspace formed in the board. Concretely, an additional board made of insulator is provided opposite to the board so as to form the airspace between the board and the additional board which are laminated one another. The gaseous insulator includes at least one though-hole formed in the board along at least one of the long direction and the width direction of the board. In these cases, the dielectric constant-reducing mechanism can be simplified and then, reduce the dielectric constant of the board, that is, the dielectric constant of the microwave circuit board.

In the case that the dielectric constant-reducing mechanism uses the airspace, the airspace may be configured so as to be located directly below the metallic conductor. The metallic conductor is strongly electrically coupled with the portion of the board directly below the metallic conductor. By providing the airspace at the corresponding portion of the board, therefore, the dielectric constant of the board can be reduced against the electrical coupling and the propagation loss in the metallic conductor can be reduced effectively.

The microwave circuit board can be formed various configurations. For example, the metallic conductor can be configured as a micro strip line (MSL) on the main surface of the board. Then, the metallic conductor can be configured as a strip line (SL) in the board. Then, a pair of ground electrodes are formed so as to sandwich the metallic conductor along the long direction of the metallic conductor with parallel to the metallic conductor so that the metallic conductor and the wiring pattern constitute a coplanar waveguide (CPW).

Particularly not exemplified, the microwave circuit board as described above according to the aspects of the present invention can be applied for various microwave circuit boards which can be considered by the person skilled in the art.

According to the aspect of the present invention can be provided a printed-wiring board which is made of a not expensive material easily available and can reduce the effective dielectric constant, that is, the dielectric loss of the printed-wiring board so that the deterioration of the signal waveform, the electric power loss and the reflecting energy of the printed-wiring board can be reduced sufficiently. Even though a plurality of metallic conductors are prepared, the crosstalk of the printed wiring board can be reduced effectively because the coupling capacitances between the metallic conductors can be reduced due to the reduction of the effective dielectric constant.

**BRIEF DESCRIPTION OF THE SEVERAL VIEWS OF THE DRAWINGS**

FIG. 1 is a perspective view illustrating an embodiment of the microwave circuit board according to the present invention.

FIG. 2 is a perspective view illustrating another embodiment of the microwave circuit board according to the present invention.

FIG. 3 is a perspective view illustrating still another embodiment modified from the microwave circuit board in FIG. 2.

FIG. 4 is a perspective view illustrating a further embodiment modified from the microwave circuit board in FIG. 2.

FIG. 5 is a perspective view illustrating a still further embodiment of the microwave circuit board according to the present invention.

FIG. 6 is a perspective view illustrating still another embodiment of the microwave circuit board according to the present invention.

DETAILED DESCRIPTION OF THE INVENTION

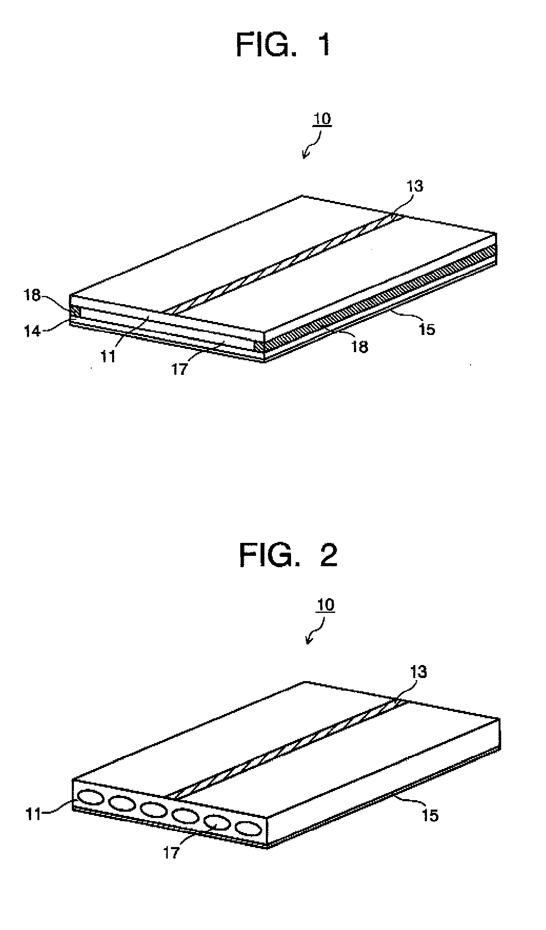

Hereinafter, the present invention will be described in detail with reference to the drawings. FIG. 1 is a perspective view illustrating an embodiment of the microwave circuit board according to the present invention. The microwave circuit board 10 illustrated in FIG. 1 includes a board 11 made of insulator, a metallic conductor 13 to transfer (a) microwave electric signal (s) which is formed on the main surface of the board 11 and an additional board 14 made of insulator which is disposed opposite to the board 11. An adhesive 18 is applied at the edges of the boards 11 and 14 along the long direction of the boards 11 and 14. Since the boards 11 and 14 are disposed via the adhesive 18, a space 17 with a given size is formed between the boards 11 and 14. Then, an electric power layer 15 is formed on the rear surface of the additional board 14.

The electric power layer 15 functions as a reference electrode for the metallic conductor 13 and is maintained constant electric potential for the metallic conductor 13 so that the microwave electric signal(s) can be transferred under good condition. The electric power layer 15 may be electrically grounded, but may be maintained a predetermined electric potential only if the microwave electric signal(s) can be transferred in the metallic conductor 13.

In this embodiment, the metallic conductor 13 is formed as a micro strip line (MSL).

In this embodiment, by decreasing the thicknesses of the boards 11 and 14 sufficiently, the effective board is composed of the boards 11 and 14 and the space 17. With the effective board, therefore, the space 17 functions as a dielectric constant-reducing mechanism so as to decrease the effective dielectric constant of the effective board, that is, the microwave circuit board 10. As a result, the dielectric loss, the electric power loss from the dielectric loss, the reflecting energy and the deterioration of the waveform of the microwave circuit board 10 can be reduced. Moreover, since an electromagnetic wave can be confined in the microwave circuit board 10, the electromagnetic radiation from the metallic conductor 13, through which the electric signal(s) are transferred, can be reduced.

In this embodiment, the metallic conductor 13 constitutes the single micro strip line. A plurality of metallic conductors may be prepared. In this case, even though a high frequency current is flowed simultaneously in the metallic conductors, the crosstalk between the metallic conductors can be reduced because the line coupling capacitance between the metallic conductors depends on the dielectric constant of the effective board and is decreased as the dielectric constant is decreased.

Since the space 17 is located directly below the metallic conductor 13 formed on the board 11, the dielectric constant of the portion of the effective board which is strongly electrically coupled with the metallic conductor 13 can be reduced sufficiently so that the propagation loss in the metallic conductor 13, originated from the dielectric loss, can be reduced effectively.

The boards 11 and 14 may be made of a given insulator. As the insulator can be exemplified paper (e.g., FR-1, FR-2, XXXpc, Xpc, FR-3), glass (e.g., FR-4, G-10, FR-5, G-11, GPY), epoxy or polyester based composite (CEM-1, CEM-3, FR-6), polyester, polyimide or glass epoxy based flexible material, polysulfone, polyetherimide or polyether thermoplastic resin, alumina, alumina nitride or silicon carbide low temperature sintered ceramic material and liquid crystal.

The metallic conductor 13 and the electric power layer 15 may be made of e.g., Cu, Ag, Au, aluminum or an alloy thereof.

The microwave circuit board 10 may be made as a rigid board or a flexible board entirely.

FIG. 2 is a perspective view illustrating another embodiment of the microwave circuit board according to the present invention. Like or corresponding components are designated by the same reference characters throughout the drawings.

The microwave circuit board 10 illustrated in FIG. 2 includes a board 11 made of insulator, a metallic conductor 13 to transfer (a) microwave electric signal(s) which is formed on the main surface of the board 11 and an electric power layer 15 is formed on the rear surface of the board 11. The electric power layer 15 functions as a reference electrode for the metallic conductor 13 and is maintained constant electric potential for the metallic conductor 13 so that the microwave electric signal(s) can be transferred under good condition. The electric power layer 15 may be electrically grounded, but may be maintained a predetermined electric potential only if the microwave electric signal(s) can be transferred in the metallic conductor 13.

In this embodiment, the metallic conductor 13 is formed as a micro strip line (MSL).

In this embodiment, a plurality of through-holes 17 are formed in the board 11 along the long direction of the board 11 so as to be parallel to one another. Therefore, the effective dielectric constant of the board 11, that is, the effective dielectric constant of the microwave circuit board 10 can be reduced. As a result, the dielectric loss, the electric power loss from the dielectric loss, the reflecting energy and the deterioration of the waveform of the microwave circuit board 10 can be reduced. Moreover, since an electromagnetic wave can be confined in the microwave circuit board 10, the electromagnetic radiation from the metallic conductor 13, through which the electric signal (s) are transferred, can be reduced.

In this embodiment, the metallic conductor 13 constitutes the single micro strip line, but a plurality of metallic conductors may be prepared. In this case, even though a high frequency current is flowed simultaneously in the metallic conductors, the crosstalk between the metallic conductors can be reduced because the line coupling capacitance between the metallic conductors depends on the dielectric constant of the effective board and is decreased as the dielectric constant is decreased.

Since the through-hole 17 is located directly below the metallic conductor 13 formed on the board 11, the dielectric constant of the portion of the effective board which is strongly electrically coupled with the metallic conductor 13 can be reduced sufficiently so that the propagation loss in the metallic conductor 13, originated from the dielectric loss, can be reduced effectively.

The board 11 may be made of a given insulator. As the insulator can be exemplified paper (e.g., FR-1, FR-2, XXXpc, Xpc, FR-3), glass (e.g., FR-4, G-10, FR-5, G-11, GPY), epoxy or polyester based composite (CEM-1, CEM-3,FR-6), polyester, polyimide or glass epoxy based flexible material, polysulfone, polyetherimide or polyether thermoplastic resin, alumina, alumina nitride or silicon carbide low temperature sintered ceramic material and liquid crystal.

The metallic conductor 13 and the electric power layer 15 may be made of e.g., Cu, Ag, Au, aluminum or an alloy thereof.

The microwave circuit board 10 may be made as a rigid board or a flexible board entirely.

The through-holes 17 can be formed as follows. First of all, a plurality of insulating members to constitute the board 11 are prepared, and shaped under the condition that a resin is infiltrated into the spaces between the insulating members, thereby forming a compact. Then, the resin is removed from the compact. In this case, the compact itself constitutes the board 11, and the portions of the compact from which the resin is removed constitute the through-holes 17. Then, the metallic conductor 13 is formed on the main surface of the board 11 and the electric power layer 15 is formed on the rear surface of the board 11, thereby forming the microwave circuit board 10 as illustrated in FIG. 2.

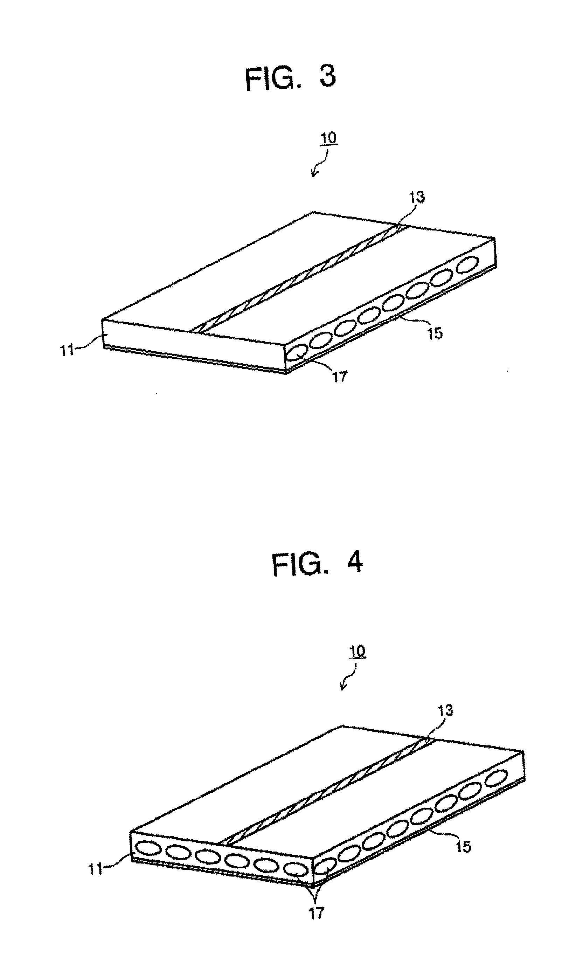

FIG. 3 is a perspective view illustrating still another embodiment modified from the microwave circuit board 10 in FIG. 2. The microwave circuit board in this embodiment can be configured in the same manner as the microwave circuit board 10 in FIG. 2 except the structure of the through-holes 17 formed in the board 11. Like or corresponding components are designated by the same reference characters throughout the drawings, and are not explained repeatedly.

In the embodiment relating to FIG. 2, the through-holes 17 are formed along the long direction of the board 11 so as to be parallel to one another. In this embodiment relating to FIG. 3, the through-holes 17 are formed along the width direction of the board 11. In this embodiment, according to the through-holes 17, the effective dielectric constant of the board 11, that is, the effective dielectric constant of the microwave circuit board 10 can be reduced. As a result, the dielectric loss, the electric power loss from the dielectric loss, the reflecting energy and the deterioration of the waveform of the microwave circuit board 10 can be reduced. Moreover, since an electromagnetic wave can be confined in the microwave circuit board 10, the electromagnetic radiation from the metallic conductor 13, through which the electric signal(s) are transferred, can be reduced.

In this embodiment, the metallic conductor 13 constitutes the single micro strip line, but a plurality of metallic conductors may be prepared. In this case, even though a high frequency current is flowed simultaneously in the metallic conductors, the crosstalk between the metallic conductors can be reduced because the line coupling capacitance between the metallic conductors depends on the dielectric constant of the effective board and is decreased as the dielectric constant is decreased.

In this embodiment, the through-holes 17 can be formed in the same manner as in the embodiment relating to FIG. 2.

Since the through-hole 17 is located directly below the metallic conductor 13 formed on the board 11, the dielectric constant of the portion of the effective board which is strongly electrically coupled with the metallic conductor 13 can be reduced sufficiently so that the propagation loss in the metallic conductor 13, originated from the dielectric loss, can be reduced effectively.

FIG. 4 is a perspective view illustrating a further embodiment modified from the microwave circuit board 10 in FIG. 2. The microwave circuit board in this embodiment can be configured in the same manner as the microwave circuit board 10 in FIG. 2 except the structure of the through-holes 17 formed in the board 11. Like or corresponding components are designated by the same reference characters throughout the drawings, and are not explained repeatedly.

In the embodiment relating to FIG. 2, the through-holes 17 are formed along the long direction of the board 11 so as to be parallel to one another. In this embodiment relating to FIG. 4, the through-holes 17 are formed along the long direction and the width direction of the board 11. In this embodiment, according to the through-holes 17, the effective dielectric constant of the board 11, that is, the effective dielectric constant of the microwave circuit board 10 can be reduced. As a result, the dielectric loss, the electric power loss from the dielectric loss, the reflecting energy and the deterioration of the waveform of the microwave circuit board 10 can be reduced. Moreover, since an electromagnetic wave can be confined in the microwave circuit board 10, the electromagnetic radiation from the metallic conductor 13, through which the electric signal(s) are transferred, can be reduced.

In this embodiment, the metallic conductor 13 constitutes the single micro strip line, but a plurality of metallic conductors may be prepared. In this case, even though a high frequency current is flowed simultaneously in the metallic conductors, the crosstalk between the metallic conductors can be reduced because the line coupling capacitance between the metallic conductors depends on the dielectric constant of the effective board and is decreased as the dielectric constant is decreased.

Since the through-hole 17 is located directly below the metallic conductor 13 formed on the board 11, the dielectric constant of the portion of the effective board which is strongly electrically coupled with the metallic conductor 13 can be reduced sufficiently so that the propagation loss in the metallic conductor 13, originated from the dielectric loss, can be reduced effectively.

In this embodiment, the through-holes 17 can be formed in the same manner as in the embodiment relating to FIG. 2.

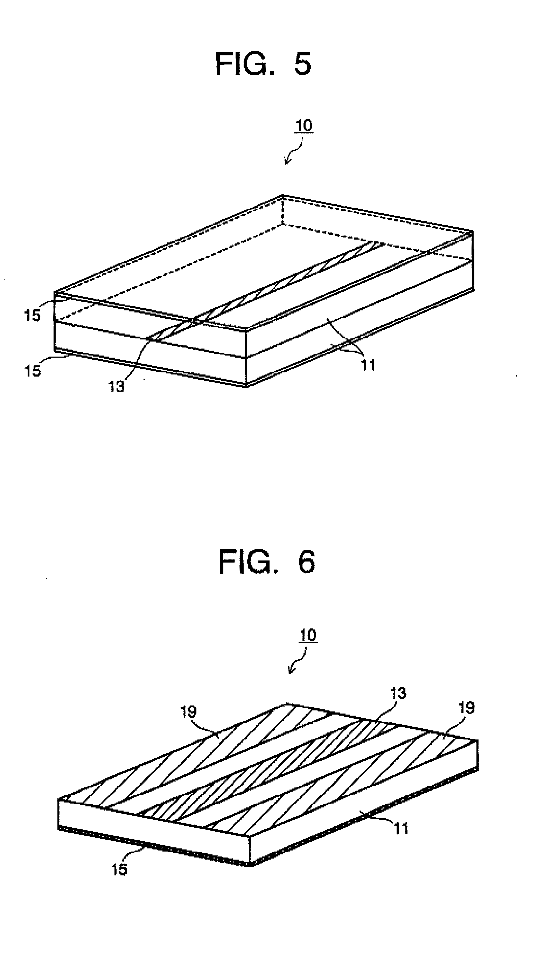

FIG. 5 is a perspective view illustrating a still further embodiment of the microwave circuit board according to the present invention. Like or corresponding components are designated by the same reference characters throughout the drawings.

The microwave circuit board 10 illustrated in FIG. 5 includes a board 11 made of insulator, a metallic conductor 13 to transfer (a) microwave electric signal(s) which is elongated parallel to the main surface and the rear surface of the board 11 and electric power layers 15 formed on the main surface and the rear surface of the board 11. The electric power layer 15 functions as a reference electrode for the metallic conductor 13 and is maintained constant electric potential for the metallic conductor 13 so that the microwave electric signal(s) can be transferred under good condition. The electric power layer 15 may be electrically grounded, butmaybe maintained a predetermined electric potential only if the microwave electric signal(s) can be transferred in the metallic conductor 13.

In this embodiment, the metallic conductor 13 is formed as a strip line (SL). In this embodiment, not illustrated clearly, the though-holes (not shown) are formed directly below the metallic conductor 13 of the board 11 in the same manner as in the embodiment relating to at least one of FIGs. 2 to 4. Therefore, the effective dielectric constant of the board 11, that is, the effective dielectric constant of the microwave circuit board 10 can be reduced. As a result, the dielectric loss, the electric power loss from the dielectric loss, the reflecting energy and the deterioration of the waveform of the microwave circuit board 10 can be reduced. Moreover, since an electromagnetic wave can be confined in the microwave circuit board 10, the electromagnetic radiation from the metallic conductor 13, through which the electric signal(s) are transferred, can be reduced.

In this embodiment, the metallic conductor 13 constitutes the single strip line, but a plurality of metallic conductors may be prepared. In this case, even though a high frequency current is flowed simultaneously in the metallic conductors, the crosstalk between the metallic conductors can be reduced because the line coupling capacitance between the metallic conductors depends on the dielectric constant of the effective board and is decreased as the dielectric constant is decreased.

Since the through-hole 17 is located directly below the metallic conductor 13 formed on the board 11, the dielectric constant of the portion of the effective board which is strongly electrically coupled with the metallic conductor 13 can be reduced sufficiently so that the propagation loss in the metallic conductor 13, originated from the dielectric loss, can be reduced effectively.

In this embodiment, the board 11 is formed of a plurality of members so as to form a space between the members as shown in the embodiment relating to FIG. 1, instead of the formation of the through-holes 17 in the board 11.

Other requirements such as the constituent materials of the board and metallic conductor in this embodiment can be determined in the same manner as the embodiments relating to FIGs. 1 to 4, and are not explained repeatedly.

FIG. 6 is a perspective view illustrating a still further embodiment of the microwave circuit board according to the present invention. Like or corresponding components are designated by the same reference characters throughout the drawings.

The microwave circuit board 10 illustrated in FIG. 6 includes a board 11 made of insulator, a metallic conductor 13 to transfer (a) microwave electric signal(s) which is formed on the main surface of the board 11 and an electric power layers 15 formed on the rear surface of the board 11. The electric power layer 15 functions as a reference electrode for the metallic conductor 13 and is maintained constant electric potential for the metallic conductor 13 so that the microwave electric signal (s) can be transferred under good condition. The electric power layer 15 may be electrically grounded, but may be maintained a predetermined electric potential only if the microwave electric signal(s) can be transferred in the metallic conductor 13.

In this embodiment, a pair of ground electrode layers 19 are formed in both sides of the metallic conductor 13 so as to sandwich the metallic conductor 13. The metallic conductor 13 and the ground electrode layers 19 constitute the coplanar waveguide (CPW).

In this embodiment, not illustrated clearly, the though-holes (not shown) are formed directly below the metallic conductor 13 of the board 11 in the same manner as in the embodiment relating to at least one of FIGs. 2 to 4. Therefore, the effective dielectric constant of the board 11, that is, the effective dielectric constant of the microwave circuit board 10 can be reduced. As a result, the dielectric loss, the electric power loss from the dielectric loss, the reflecting energy and the deterioration of the waveform of the microwave circuit board 10 can be reduced. Moreover, since an electromagnetic wave can be confined in the microwave circuit board 10, the electromagnetic radiation from the metallic conductor 13, through which the electric signal(s) are transferred, can be reduced.

In this embodiment, the metallic conductor 13 constitutes the single strip line, but a plurality of metallic conductors may be prepared. In this case, even though a high frequency current is flowed simultaneously in the metallic conductors, the crosstalk between the metallic conductors can be reduced because the line coupling capacitance between the metallic conductors depends on the dielectric constant of the effective board and is decreased as the dielectric constant is decreased.

Since the through-hole 17 is located directly below the metallic conductor 13 formed on the board 11, the dielectric constant of the portion of the effective board which is strongly electrically coupled with the metallic conductor 13 can be reduced sufficiently so that the propagation loss in the metallic conductor 13, originated from the dielectric loss, can be reduced effectively.

In this embodiment, the board 11 is formed of a plurality of members so as to form a space between the members as shown in the embodiment relating to FIG. 1, instead of the formation of the through-holes 17 in the board 11.

Other requirements such as the constituent materials of the board and metallic conductor in this embodiment can be determined in the same manner as the embodiments relating to FIGs. 1-4, and are not explained repeatedly.

(Example)

In this Example, a microwave circuit board as illustrated in FIG. 2 was fabricated and the characteristics of the thus obtained microwave circuit board were investigated. As parameters, the length "1" of the board 11 of the microwave circuit board, the radius "r" of the through-hole 17 and the pitch (distance) "g" between the adjacent through-holes 17 were defined. When the length "1", the radius "r" and the pitch "g" were set to 1cm, 0.045cm and 1mm, respectively, the propagation loss and the reflecting loss of the microwave circuit board in this Example were improved by 5.5 dB and 18 dB, respectively, in comparison with the microwave circuit board without the through-holes under the condition that an electric signal with a frequency of 20 GHz was transferred under impedance match. Then, the EMC of the microwave circuit board was improved by 30 dB$\mu$V by means of 3m method under the condition that an electric signal of 10Gbps was transferred.

Namely, by forming the through-holes in the board according to the present invention, the electric power loss and the reflecting energy can be reduced and the deterioration of the signal waveform can be suppressed.

Although the present invention was described in detail with reference to the above examples, this invention is not limited to the above disclosure and every kind of variation and modification may be made without departing from the scope of the present invention.

**Claims**

1. A microwave circuit board, comprising:

   a board made of insulator;
   a metallic conductor to transfer an electric signal which is formed on at least one of a main surface and a rear surface of said board; and
   an electric power layer formed on said rear surface of said board and/or in said board,

   wherein said board includes an dielectric constant-reducing mechanism so as to reduce an effective dielectric constant of said board.

2. The microwave circuit board as set forth in claim 1,
   wherein said dielectric constant-reducing mechanism uses a gaseous insulator.

3. The microwave circuit board as set forth in claim 2,
   wherein said dielectric constant-reducing mechanism includes an airspace formed in said board.

4. The microwave circuit board as set forth in claim 3, further comprising an additional board made of insulator and configured so as to be opposite to said board,

wherein said airspace is a space formed between said board and said additional board which are laminated one another.

5. The microwave circuit board as set forth in claim 3,
wherein said airspace includes at least one though-hole formed in said board along at least one of a long direction and a width direction of said board.

6. The microwave circuit board as set forth in claim 4,
wherein said airspace is located directly below said metallic conductor of said board.

7. The microwave circuit board as set forth in claim 5,
wherein said airspace is located directly below saidmetallic conductor of said board.

8. The microwave circuit board as set forth in claim 1,
wherein said metallic conductor constitutes a micro strip line (MSL) on said main surface of said board.

9. The microwave circuit board as set forth in claim 1,
wherein said metallic conductor constitutes a strip line (SL) on said main surface of said board.

10. The microwave circuit board as set forth in claim 1, further comprising a pair of ground electrodes formed so as to sandwich said metallic conductor along a long direction of said metallic conductor with parallel to said metallic conductor so that said metallic conductor and said wiring pattern constitute a coplanar waveguide (CPW).

11. A method for manufacturing a microwave circuit board, comprising:

preparing a plurality of insulating members, and shaping said insulating members under the condition that a resin is infiltrated into spaces formed between said insulating members, thereby forming a compact;
removing said resin from said compact, thereby forming a board made of insulator of said insulating members and containing an airspace therein;
forming a metallic conductor to transfer a microwave electric signal on said rear surface of said board and/or in said board; and
forming an electric power layer on said rear surface of said board and/or in said board.

12. The manufacturing method as set forth in claim 11,
wherein said airspace is configured so as to contain at least one through-hole formed along at least one of a long direction and a width direction of said board.

## FIG. 1

## FIG. 2

# FIG. 3

# FIG. 4

# FIG. 5

# FIG. 6

## REFERENCES CITED IN THE DESCRIPTION

**Patent documents cited in the description**

- JP 2006350285 A
- JP 62016566 B
- JP 8228105 A
- JP 2001007610 A
- JP 4257287 A
- JP 2003115705 A